# NEW EUROPEAN PATENT SPECIFICATION

(11) **EP 1 245 328 B2**
(45) Date of publication and mention of the opposition decision: **20.12.2017**
(45) Mention of the grant of the patent: 16.06.2010
(21) Application number: 01400534.2
(22) Date of filing: 01.03.2001
(51) Int. Cl.: B23K 35/26

(54) **Use of silver in a lead-free solder paset**
Verwendung von Silber in einer bleifreien Lötpaste
Usage d'Argent dans une p^te de brasage sans plomb

(43) Date of publication of application: 02.10.2002
(60) Divisional application: 09175462.2
(73) Proprietor: SENJU METAL INDUSTRY CO., LTD., Tokyo, 120-8555 (JP)
(72) Inventor: Katoh, Rikiya, Sohka-shi, Saitama (JP); Munekata, Osamu, Koshigaya-shi, Saitama (JP); Toyoda, Yoshitaka, Satte-shi, Saitama (JP)
(74) Representative: Zimmermann & Partner Patentanwälte mbB

(56) References cited:
- EP-A- 0 251 611
- EP-A- 0 499 452
- EP-A- 0 710 521
- WO-A-00/48784
- JP-A- 09 327 790
- JP-A- H08 215 880
- JP-A- H11 221 695
- US-A- 4 670 217
- US-A- 6 139 979
- LAINE-YLIJOKI T ET AL: "DEVELOPMENT AND VALIDATION OF A LEAD-FREE ALLOY FOR SOLDER PASTE APPLICATIONS" IEEE TRANSACTIONS ON COMPONENTS, PACKAGING AND MANUFACTURING TECHNOLOGY. PART C: MANUFACTURING, IEEE SERVICE CENTER, PISCATAWAY, NJ, US, vol. 20, no. 3, PART C, 1 July 1997 (1997-07-01), pages 194-198, XP000722468 ISSN: 1083-4400
- ' Soldering and Brazing' ULLMANN'S ENCYCLOPEDIA OF INDUSTRIAL CHEMISTRY 1993, pages 427 - 436
- R.J. KLEIN WASSINK: ' Soldering in Electronics' 1989, pages 195 - 196
- ' ASTM Designation D 3418 - O3' STANDARD TEST METHOD FOR TRANSITION TEMPERATURES OF POLYMERS
- ' ASTM Designation E 793-01' STANDARD TEST METHOD FOR ENTHALPIES OF FUSION AND CRYSTALLIZTION BY DIFFERENTIAL SCANNING CALORIMETRY
- LOOMANANS M.E. ET AL: 'Journal of Electronic Materials' INVESTIGATION OF MULTI-COMPONENT LEAD-FREE SOLDERS vol. 23, no. 8, 1994, page 746, XP 741
- 'JIS-Japanese Industrial Standard "Solder Paste" JIS Z 3284' 1994,
- HWANG J.S,: 'Solder Paste in Electronics Packaging' 1989, VAN NOSTRAND REINHOLD VERLAG,
- 'Skizze basierend auf Figur 2 der D2'
- 'Uebersetzung der D3 (mit Uebersetzerbeglaubigung)'
- 'UEBERSETZUNG DER D4 (MIT UEBERSETZERBEGLAUBIGUNG)'
- 'DSC-Kurve (differential scanning calorimetry curve) der Lotlegierung Sn-Ag0,5-Cu1,0 (aufgenommen von der Einsprechenden)'
- 'DSC-Kurve der Lotlegierung Sn-Ag1,0-Cu1,0 (aufgenommen von der Einsprechenden)'

## Description

### Background of the Invention

### 1. Field of the Invention

This invention relates to the use of Ag in a lead-free solder paste which is suitable for reflow soldering of chip components and which can prevent the occurrence of tombstoning during reflow soldering.

### 2. Description of the Related Art

Among soldering methods commonly in use today, the reflow soldering method is particularly suitable for bonding extremely small electronic components to printed circuit boards. In reflow soldering, a solder paste containing a fine solder powder and a flux is applied to selected areas of a printed circuit board by screen printing through a metal mask or silk screen. Electronic devices are then mounted on the applied solder paste and temporarily held in place on the printed circuit board by the stickiness of the solder paste. The printed circuit board and the electronic devices are then heated, usually in a furnace, to melt the solder powder in the paste. The molten paste is then cooled to solidify the molten solder, thereby forming soldered joints between the electronic devices and the circuit board.

The reflow soldering method enables minute electronic devices to be precisely positioned on a printed circuit board, and there is no undesired bridging of solder between adjoining electronic devices, so it can produce printed circuit boards of high accuracy and reliability. This method also has excellent productivity.

However, one problem which has been encountered when soldering minute electronic components to printed circuit boards by reflow soldering is the phenomenon of tombstoning (also referred to as the Manhattan phenomenon). In this phenomenon, one end of an electronic device becomes detached from a printed circuit board during reflow while its opposite end remains bonded to the circuit board, as a result of which the one end rises and the electronic device assumes a more or less vertical orientation. Tombstoning is caused by a difference in the time at which solder paste is melted at opposite ends of an electronic device during heating in a reflow furnace. The surface tension which molten solder exerts on an electronic component is greater than the adhesive force exerted by the tackiness of the solder in an unmelted state. Accordingly, if solder paste at a first end of an electronic device melts while the solder paste at a second end of the device is still unmelted, the surface tension exerted by the molten solder at the first end exerts a downward force on the first end which may be strong enough to detach the second end of the electronic device from the printed circuit board and cause the second end to swing upwards about the first end. When an electronic device undergoes tombstoning, the second end of the electronic device is not electrically connected to the printed circuit board, so the device cannot function properly. Tombstoning is particularly a problem with leadless chip components, which are extremely small and commonly have maximum dimensions less than a millimeter, making them very susceptible to tombstoning when there is an imbalance in the forces acting on their ends during reflow soldering.

It has been discovered that tombstoning can be prevented by the use of a twin-peak solder alloy, which is an alloy which has two peaks in a DSC (differential scanning calorimeter) curve between its solidus and liquidus temperatures, with some phase transformation occurring at the temperature of each peak. In contrast, a eutectic solder alloy has only a single peak in a DSC curve between its solidus and liquidus temperatures.

However, twin-peak solder alloys which have been proposed thus far for use in solder pastes are lead-containing solders. For example, U.S. Patent No. 6,050,480 discloses twin-peak solder alloys containing up to nearly 40 mass % of lead.

In recent years, there has been a movement in the electronics industry away from the use of lead-containing solders due to the environmental damage which can occur when electronic equipment employing lead-containing solders is discarded in landfills and lead in the solder leaches into the water supply.

WO 0048784 discloses a method for reducing susceptibility to tombstoning by mixing two types of solder alloy powders to obtain the final alloy.

JP H8-215880 A discloses lead-free solder composition of the remainder Sn, 0.5-3.5% by weight Ag, and 0.5-2.0% by weight Cu.

Accordingly, there is a great need by the electronics industry for a lead-free solder paste which is suitable for reflow soldering of electronic devices without the occurrence of tombstoning.

### Summary of the Invention

The present invention is related to the use of 0.2-1.0 mass percent of Ag in a lead-free solder paste for preventing tombstoning as defined in claim 1.

Preferably the magnitude of the first peak is less than or equal to the magnitude of the second peak.

The solder alloy may include various additional components, such as a strength improving element or an oxidation preventing element.

### Brief Description of the Drawings

Figure 1 is a DSC (differential scanning calorimeter) curve of a Sn-0.5Ag solder alloy.
Figure 2 is a DSC curve of a Sn-1Ag solder alloy.
Figure 3 is a DSC curve of a Sn-0.5Ag-0.1Ni solder alloy.
Figure 4 is a DSC curve of a Sn-1Ag-0.1P solder alloy.
Figure 5 is a DSC curve of a Sn-3.5Ag solder alloy.
Figure 6 is a DSC curve of a Sn-2Ag-0.5Cu solder alloy.

### Description of Preferred Embodiments

A twin-peak solder alloy using Ag in a solder paste according to the present invention is thought to prevent tombstoning by undergoing gradual melting over a range of temperatures and thereby prolonging the time during which melting takes place. With a eutectic solder alloy, if solder begins melting at different times at opposite ends of an electronic device, the solder at one end of the electronic device may reach a completely melted state while the solder at the opposite end of the electronic device is still in an unmelted state. In this case, the solder in a completely melted state will exert a much greater tensile force on the electronic device than the unmelted solder, and the imbalance in tensile forces may cause tombstoning of the electronic device. With a twin-peak solder alloy, the forces acting on opposite ends of an electronic device during melting of the solder can be balanced so as to prevent tombstoning. If the solder at a first end of an electronic device begins to melt before the solder at the second end, since melting takes gradually, before the solder at the first end has completely melted, the solder at the second end begins to melt, so a state is achieved in which the solder at both ends is in a half-melted state. Namely, when the solder at the first end begins to melt, it exerts a weak surface tension in a half-melted state, but the surface tension in this state is not large enough to overcome the adhesive force acting on the second of the electronic device by the unmelted solder at the second end. When the solder at the second end begins to melt, it exerts a weak surface tension on the second end, which is stronger than the adhesive force which it exerted in an unmelted state. When the solder at the first end subsequently reaches a completely molten state, it exerts a stronger surface tension on the first end. However, the surface tension exerted by the half-melted solder at the second end is sufficiently great to resist the stronger surface tension exerted by the completely melted solder at the first end, so no tombstoning takes place.

Thus, a twin-peak solder can prevent tombstoning during reflow soldering by achieving a balance between the tensile forces acting on opposite ends of an electronic device. It is thought that tombstoning can be most effectively prevented when the ratio of the tensile forces acting on opposite ends of an electronic device during melting of solder is at most approximately 0.5.

If the solidification temperature range (the difference between the liquidus and solidus temperatures) for a twin-peak solder alloy is too small, tombstoning cannot be prevented, since the melting behavior of the solder alloy will resemble that of a eutectic solder alloy. On the other hand, if the solidification temperature range is very broad, a long time is required for melting, which may result in corrosion of electrodes or the growth of undesirable compounds in the regions being soldered, producing a decrease in the strength of the bonding interface. A large solidification range also prolongs the length of time required for solidification, increasing the chances of cracks being produced in soldered joints by vibrations or impacts applied to the joints during the process of solidification. Therefore, the solidification range of a twin-peak solder alloy using Ag in a solder paste according to the present invention is preferably in the range of approximately 10 to 15 °C.

Preferably the first peak of heat absorption in the DSC curve of a twin-peak solder alloy used in the present invention is less than or equal in magnitude to the second peak, since this is advantageous in causing the forces acting on an electronic device due to the surface tension of molten solder to gradually increase as melting proceeds. However, the desired effect cannot be obtained when the first peak is extremely small. Tombstoning can most effectively be prevented when the first and second peaks of heat absorption are approximately equal in magnitude.

The melting point of the Sn-based solder alloy may be 220°C or above.

The Ag content of the solder alloy is preferably 0.2 - 1.0 mass %. If the Ag content of the solder alloy is less than 0.2 mass %, the first peak of heat absorption becomes extremely small compared to the second peak. In this case, very little force due to surface tension acts on an electronic device at the temperature of the first peak, and the force due to surface tension suddenly increases at the second peak, so there is an inadequate balance between the forces acting on opposite ends of an electronic device, and tombstoning cannot be effectively prevented. On the other hand, if the solder alloy contains more than 1.0 mass % of Ag, the first peak of heat absorption in the DSC curve becomes significantly larger than the second peak, and the second peak substantially disappears. In this case as well, an imbalance develops between the forces due to surface tension action on opposite ends of an electronic device, and tombstoning cannot be effectively prevented.

The solder alloy may consist essentially of Sn and Ag, and it also comprise at least one of a variety of additional element for providing the alloy with desired properties. For example, it may include one or more elements selected from strength improving elements to improve mechanical properties, and oxidation preventing elements to prevent oxidation of the solder alloy during heating at the time of reflow soldering.

Examples of strength improving elements include Sb, Cu, Ni, Co, Fe, Mn, Cr, and Mo, one or more of which may be employed. Any one of these metals forms a solid solution or an intermetallic compound with Sn to improve mechanical strength. If the amount of these elements which is added is too large, the liquidus temperature of the solder alloy undesirably increases. Therefore, the total amount of Sb and Cu is preferably at most 1% of the total mass of the solder alloy, while the total amount of Ni, Co, Fe, Mn, Cr, and Mo is preferably at most 0.3% of the total mass of the solder alloy.

Examples of oxidation preventing elements include one or more of P, Ga, and Ge. If too large a quantity of these elements is added, the liquidus temperature of the solder alloy undesirably increases, so the total amount of these elements is preferably at most 0.2 mass % of the total mass of the solder alloy.

A solder paste using Ag according to the present invention may be prepared by mixing the solder powder with a viscous flux in a conventional manner. Normally the solder powder will have a particle size between 100 and 400 mesh. Such a solder powder may be prepared by any appropriate technique, including inert gas (e.g., argon or nitrogen gas) atomization and centrifugal spraying, for example.

The viscous flux to be mixed with the solder powder may be either a non-water soluble flux or a water-soluble flux. A typical non-water soluble flux is a rosin-based flux, but other non-water soluble fluxes may be used. The rosin may be either polymerized or unpolymerized. The flux normally comprises a base material such as a rosin, a small amount of an activator, and optionally a thixotropic agent in a solvent. Examples of an activator for rosin include amine hydrohalide salts, amine organic acid salts, and organic acids. Examples of a thixotropic agent include hydrogenated castor oil. Solvents useful for non-water soluble fluxes include glycol ethers, lower alcohols, and terpene.

The proportions of the solder powder and the flux are typically selected so as to give a mixture having a consistency suitable for printing. Generally, the weight ratio of the solder powder to the flux is in the range of from 80:20 to 95:5 and preferably from 85:15 to 92:8.

The solder paste can be applied to selected areas on a printed circuit board by screen printing or other convenient method. After electronic devices are mounted on the applied solder paste, the circuit board is heated in a reflow furnace to melt the solder alloy, thereby bonding the electronic devices to the circuit board.

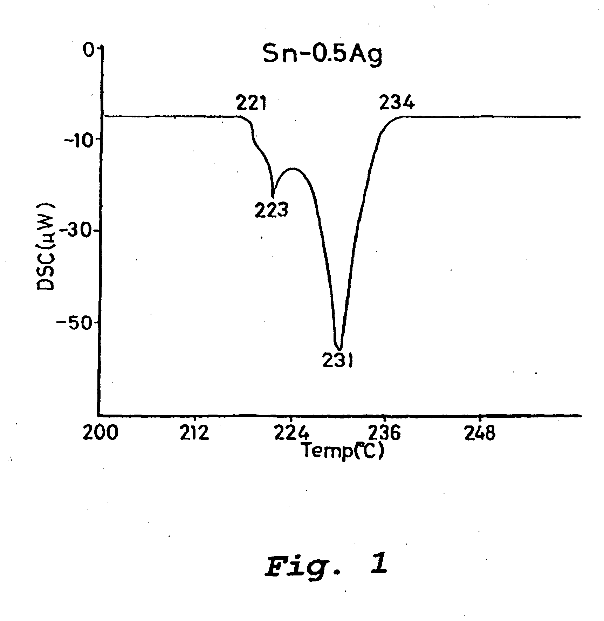

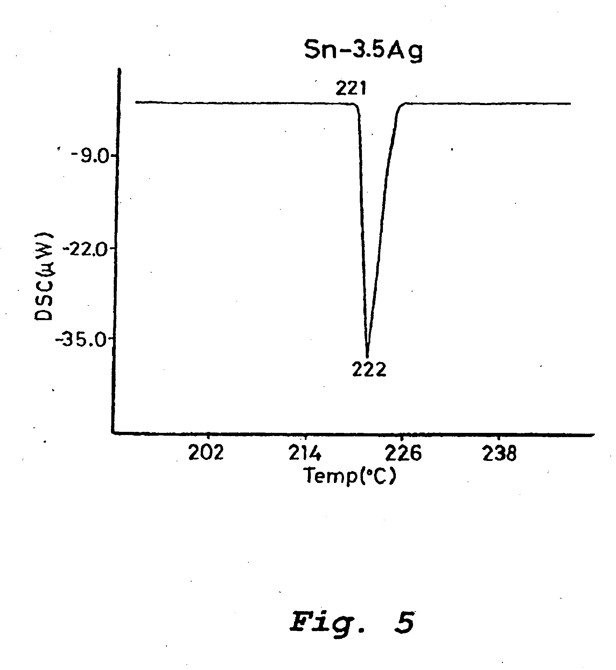

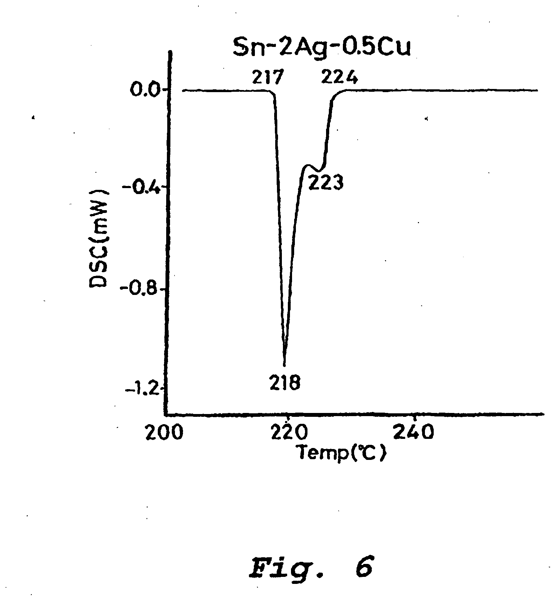

Figures 1-4 are DSC curves of lead-free solder alloys in which Ag is used in a solder paste according to the present invention, and Figures 5 and 6 are DSC curves of comparatives examples of lead-free solder alloys.

First, the lead-free solder alloys of Figure 5 and Figure 6 will be explained. Figure 5 is a DSC curve of a eutectic Sn-3.5Ag solder alloy, and Figure 6 is a DSC curve for a Sn-2Ag-0.5Cu solder alloy.

Since the Sn-3.5Ag solder alloy of Figure 5 is a binary eutectic alloy, it has only a single large peak of heat absorption at 222°C, slightly above the eutectic temperature of 221°C. When reflow soldering is performed using this solder, the force due to surface tension acting on an end of an electronic device being soldered suddenly increases at the heat absorption peak of 222°C, and tombstoning can easily take place.

The Sn-2Ag-0.5Cu solder alloy of Figure 6 begins to melt at 217°C, a first large peak of heat absorption appears immediately thereafter at 218°C, and the major portion of the solder alloy begins to melt. A second peak of heat absorption then appears at 223°C and the remaining portion melts, and then the solder alloy entirely completes melting at 224°C, so it exhibits two peaks of heat absorption in its DSC curve. However, the first peak is much larger than the second peak, and the force due to surface tension suddenly increases at the first peak, so when this solder alloy is used for reflow soldering, an imbalance develops between the forces acting on opposite ends of an electronic device being soldered, and there is a significant likelihood of tombstoning taking place.

Figure 1 is a DSC curve for a Sn-0.5Ag lead-free solder alloy. It begins melting at 221°C, a first large peak of heat absorption appears immediately thereafter at 223°C, a second peak of heat absorption which is larger then appears at 231°C, and melting is entirely completed at 234°C.

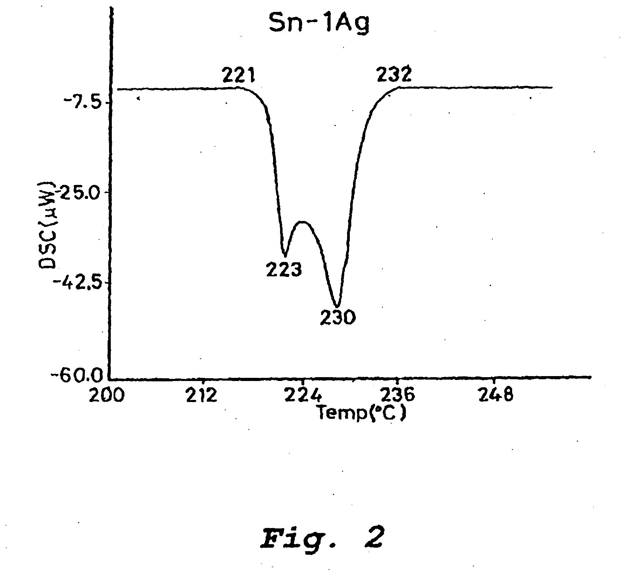

Figure 2 is a DSC curve for a Sn-1Ag lead-free solder alloy. It begins melting at 221°C, a first large peak of heat absorption appears immediately thereafter at 223°C, a second large peak of heat absorption then appears at 230°C, and melting is entirely completed at 232°C.

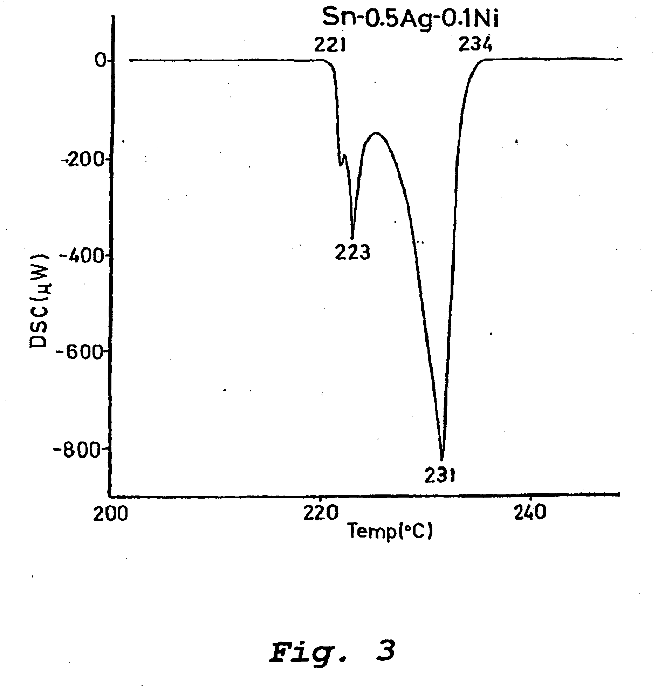

Figure 3 is a DSC curve for a Sn-0.5Ag-0.1Ni lead-free solder alloy. It begins to melt at 221°C, a first large peak of heat absorption appears immediately thereafter at 223°C, a second peak of heat absorption which is larger than the first peak then appears at 231°C, and melting is entirely completed at 234°C.

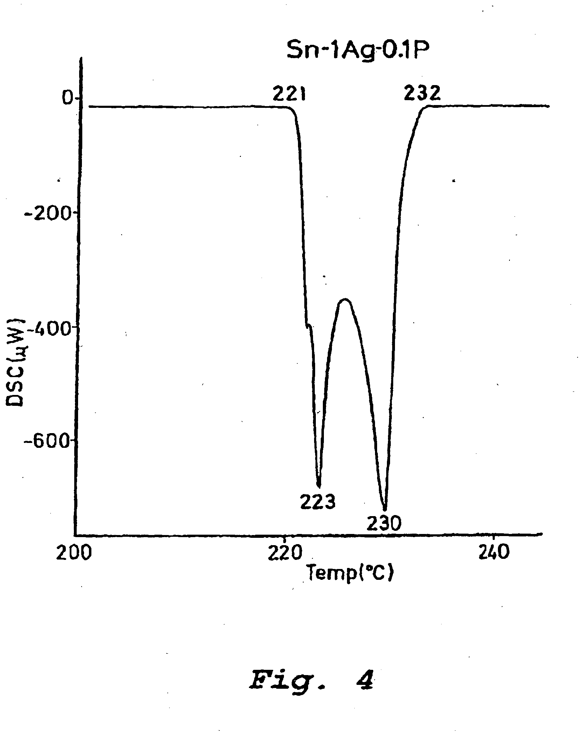

Figure 4 is a DSC curve for a Sn-1Ag-0.1P lead-free solder alloy. It begins to melt at 221°C, a first large peak of heat absorption appears immediately thereafter at 223°C, a second large peak of heat absorption then appears at 230°C, and melting is entirely completed at 232°C.

Each of the solder alloys of Figures 1 - 4 is a twin-peak alloy with two peaks of heat absorption in a DSC curve between its solidus and liquidus temperatures, with the first peak being less than or equal in magnitude than the second peak and occurring at the start of melting, and the major portion of melting occurs at the second peak. Therefore, each of these alloys exhibits a gradual melting pattern which can effectively prevent tombstoning.

### Examples

The following examples illustrate the performance of a lead-free solder paste using Ag according to the present invention and of comparative examples of a lead-free solder paste when used in reflow soldering.

### Example 1

In this example, powder of a high temperature solder alloy containing 0.5% Ag and a remainder of Sn (average particle diameter of 30µm) was mixed with a conventional resin-type flux in the following proportions to obtain a solder paste.
Lead-free solder alloy powder: Sn-0.5Ag 90 mass %
Paste-type flux: 10 mass %

Figure 1 is a DSC curve of the solder alloy of this example.

### Example 2

A solder paste having the composition described below was obtained in the same manner as in Example 1.
Lead-free solder alloy powder: Sn-1Ag-0.1Ni 90 mass %
Paste-type flux: 10 mass %

### Comparative Example 1

In this example, the procedure of Example 1 was repeated to obtain a solder paste having the following composition.
Lead-free solder alloy powder: Sn-3.5Ag 90 mass %
Paste-type flux: 10 mass %

Figure 5 is a DSC curve for the solder alloy of this example.

### Comparative Example 2

In the same manner as in Comparative Example 1, a solder paste having the following composition was obtained.
Lead-free solder alloy powder: Sn-2Ag-0.5Cu 90 mass %
Paste-type flux: 10 mass %

Figure 6 is a DSC curve for the solder alloy of this example.

A tombstoning test was carried out using the solder pastes of the above-described examples of the present invention and comparative examples. In the tombstoning test, solder was applied by printing using a mask on a printed circuit board, and then 1600 type-1005 chip components (having rectangular dimension of 1 mm in length and 0.5 mm in width) were mounted on the regions of the printed circuit board where the solder paste had been applied. The printed circuit board and the chip components were heated in a reflow furnace to melt the solder paste and solder the chip components to the printed circuit board. After soldering, the number of chip components which had undergone tombstoning was counted.

There was no tombstoning of any of the chip components soldered using the solder pastes of Example 1 and Example 2 according to the present invention. In contrast, 13 chip components underwent tombstoning for Comparative Example 1, and 6 chip components underwent tombstoning for Comparative Example 2, illustrating the high reliability of a lead-free solder paste using Ag according to the present invention compared to conventional lead-free solder pastes.

## Claims

1. Use of 0.2 - 1.0 mass percent of Ag in a Pb-free solder paste for preventing tombstoning during reflow soldering of leadless chip components, wherein the solder paste consists in a mixture of a powder of a lead-free Sn-based twin-peak solder alloy powder mixed with a flux, and wherein the solder alloy, after addition of the Ag, consists of 0.2 - 1.0 mass percent of Ag, at least one of the below-listed (i)-(iii), and the balance of Sn and having a first peak of heat absorption in a differential scanning calorimeter curve at the start of melting of the solder alloy and a second peak when the major portion of the solder alloy subsequently melts:
(i) at least one element of Sb and Cu in a total amount of at most 1.0 mass percent;
(ii) at least one element selected from the group consisting of Ni, Co, Fe, Mn, Cr and Mo in a total amount of at most 0.3 mass percent;
(iii) at least one element selected from the group consisting of P, Ga and Ge in a total amount of at most 0.2 mass percent.

## Patentansprüche

1. Verwendung von 0,2 - 1,0 Masseprozent Ag in einer bleifreien Lotpaste zur Verhinderung des Grabsteineffekts beim Reflowlöten von beinchenlosen Chipkomponenten, wobei die Lotpaste aus einer Mischung eines Pulvers aus einem bleifreien Sn-basierten Doppelpeak-Lotlegierungspulver gemischt mit einem Flussmittel besteht, und wobei die Lotlegierung nach Zugabe des Ag aus 0,2 - 1,0 Masseprozent Ag, wenigstens einem der unten aufgelisteten Elemente (i)-(iii) und dem Rest aus Sn besteht, sowie einen ersten Wärmeabsorptionspeak in einer Kurve eines Differential-Scanning-Kalorimeters bei Schmelzbeginn der Lötlegierung und einem zweiten Peak beim nachfolgenden Schmelzen des Hauptanteils der Lötlegierung aufweist:
(i) wenigstens ein Element aus Sb und Cu in einer Gesamtmenge von maximal 1,0 Masseprozent;
(ii) wenigstens ein Element, ausgewählt aus der Gruppe, bestehend aus Ni, Co, Fe, Mn, Cr und Mo, in einer Gesamtmenge von maximal 0,3 Masseprozent;
(iii) wenigstens ein Element, ausgewählt aus der Gruppe bestehend aus P, Ga und Ge in einer Gesamtmenge von maximal 0,2 Masseprozent.

## Revendications

1. Utilisation de 0,2 à 1,0 % en masse d'Ag dans une pâte à braser sans plomb pour empêcher le phénomène « tombstoning » (phénomène pierre tombale) lors du brasage par refusion de composants de puce sans broche, dans laquelle la pâte à braser consiste en un mélange d'une poudre d'une poudre d'alliage à braser sans plomb à double pics à base de Sn mélangée à un flux, et dans laquelle l'alliage à braser, après addition de l'Ag, consiste en 0,2 à 1,0 % en masse d'Ag, au moins un des éléments suivants (i) à (iii), et le reste étant du Sn, et ayant un premier pic d'absorption de chaleur dans une courbe de calorimètre à balayage différentiel au début de la fusion de l'alliage à braser et un second pic lorsque la majeure partie de l'alliage à braser fond par la suite:
(i) au moins un élément de Sb et Cu dans une quantité totale d'au plus 1,0 % en masse;
(ii) au moins un élément choisi dans le groupe consistant en Ni, Co, Fe, Mn, Cr et Mo dans une quantité totale d'au plus 0,3 % en masse;
(iii) au moins un élément choisi dans le groupe consistant en P, Ga et Ge dans une quantité totale d'au plus 0,2 % en masse.
